# EUROPEAN PATENT APPLICATION

(11) **EP 2 648 222 A1**
(43) Date of publication of application: **09.10.2013**
(21) Application number: 13162263.1
(22) Date of filing: 04.04.2013
(51) Int. Cl.: H01L 31/0224, H01L 31/0216, H05K 3/24, C23C 18/16, C23C 18/54

(54) **Metal plating for pH sensitive applications**

(30) Priority: 04.04.2012 US 201213439617
(71) Applicant: Rohm and Haas Electronic Materials LLC, Marlborough, MA 01752 (US)
(72) Inventor: Hamm, Gary, Billerica, MA Massachusetts 01821 (US); Jacques, David L., Northbridge, MA Massachusetts 01534 (US); Reese, Jason A., Londonderry, NH New Hampshire 03053 (US)
(74) Representative: Buckley, Guy Julian

(57) **Abstract**

Metal electroplating processes are used in pH sensitive applications to plate metal layers on semiconductors. The semiconductors may be used in the manufacture of photovoltaic devices and solar cells.

## Description

### Field of the Invention

The present invention is directed to metal plating for pH sensitive applications. More specifically, the present invention is directed to metal plating for pH sensitive applications in the manufacture of semiconductor containing devices where adhesion failure between metal layers and the semiconductor is prevented.

### Background of the Invention

Metal plating of doped semiconductors, such as photovoltaics and solar cells, involves the formation of electrically conductive contacts on front and back sides of the semiconductors. The metal coating must be able to establish ohmic contact with the semiconductor in order to ensure that charge carriers emerge from the semiconductor into the electrically conductive contacts without interference. In order to avoid current loss, metallized contact grids must have adequate current conductivities, i.e. a high conductivity or a sufficiently high conductor track cross section.

Numerous processes which meet the above requirements exist for metal coating the back sides of solar cells. For example, in order to improve current conduction at the back side of solar cells, p-doping directly under the back side is reinforced. Usually aluminum is used for this purpose. The aluminum is applied, for example, by vapor deposition or by being printed onto the back side and being driven in or, respectively, alloyed in. When metal coating the front sides, or light incidence sides, the objective is to achieve the least amount of shading of the active semiconductor surface in order to use as much of the surface as possible for capturing photons.

Metal coatings using thick-film techniques are conventional methods for metallizing conductor tracks. Pastes used include metal particles, such as silver, and are electrically conductive as a result. The pastes are applied by screen, mask, pad printing or paste writing. A commonly used process is the screen printing process where finger-shaped metal coating lines having a minimum line width of 80µm to 100µm are made on the front side or emitter layer side of the doped semiconductor. After the paste is applied it is fired to form a metal frit which makes electrical contact with the emitter layer of the doped semiconductor. The fired metal paste is then typically plated with one or more layers of copper metal to build-up the conductor tracks. A metal barrier layer is first plated, such as a nickel layer, to prevent any copper from diffusing into the emitter layer and damaging it. After the copper layer is plated a flash layer of silver or tin may be plated to protect the copper layer from undesired oxidation. Copper is typically plated from acid copper plating baths. Unfortunately, many such conventional copper plating baths as well as the metal baths used to plate the barrier layer and the flash layer corrode the metal frit joining the emitter layer to the added metal layers. This results in adhesion failure between the emitter layer and the metal frit along with the metal layers. Accordingly, there is a need for a new method for depositing metal layers on fired paste which inhibit or prevent corrosion of the metal frit thus preventing adhesion failure.

### Summary of the Invention

Methods include providing a semiconductor including a front side, a metalized back side, and a PN junction, the front side includes a pattern of conductive tracks including fired metal paste; depositing a barrier layer on the conductive tracks; contacting the semiconductor with a copper plating bath including one or more sources of copper ions, one or more sources of chloride ions and bromide ions, one or more sources of nitrate ions, sulfate ions and bisulfate ions, and a pH of 1.5-4; and plating a copper layer adjacent the barrier layer of the fired metal paste of the conductive tracks.

Compositions include one or more sources of copper ions, one or more sources of chloride and bromide ions, one or more sources of nitrate ions, sulfate ions and bisulfate ions, and a pH of 1.5-4.

The methods and compositions enable the plating of metals on fired metal paste with minimal or no corrosion of the paste. Accordingly, the aesthetics of the semiconductor as well as the adhesion of the metals to the semiconductor are not compromised.

### Detailed Description of the Invention

As used throughout this specification, the terms "electroplating" and "plating" are used interchangeably. The terms "current tracks" and "conductive tracks" are used interchangeably. The terms "composition" and "bath" are used interchangeably. The indefinite articles "a" and "an" are intended to include both the singular and the plural. The term "selectively depositing" means that metal deposition occurs in specific desired areas on a substrate. The term "lux = lx" is a unit of illumination equal to one lumen/m²; and one lux = 1.46 milliwatt of radiant electromagnetic (EM) power at a frequency of 540 tetrahertz.

The following abbreviations have the following meanings unless the context clearly indicates otherwise: °C = degrees Celsius; g = grams; mg = milligrams; mL = milliliter; L = liter; A = amperes; dm = decimeter; N = Newtons; ASD = A/dm²; cm = centimeter; µm = micrometers; nm = nanometers; mS = millisiemens; LIP = light induced plating or light assisted plating; LED = light emitting diode; PVD = physical vapor deposition; CVD = chemical vapor deposition; V = volts; UV = ultra-violet and IR = infrared.

All percentages and ratios are by weight unless otherwise indicated. All ranges are inclusive and combinable in any order except where it is clear that such numerical ranges are constrained to add up to 100%.

The semiconductors may be composed of monocrystalline or polycrystalline or amorphous silicon. Such semiconductors are typically used in the manufacture of photovoltaic devices and solar cells. Silicon wafers typically have a p-type base doping. The semiconductor wafers may be circular, square or rectangular in shape or may be any other suitable shape. Such wafers may have a wide variety of dimensions and surface resistivities. The back side of a wafer is metalized to provide a low resistance wafer. Any conventional method may be used.

The entire back side may be metal coated or a portion of the back side may be metal coated, such as to form a grid. Busbars are typically included on the back side of the wafer. Such back side metallization may be provided by a variety of techniques. In one embodiment, a metal coating is applied to the back side in the form of an electrically conductive paste, such as a silver-containing paste, an aluminum-containing paste or a silver and aluminum-containing paste. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the back side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced. In one embodiment, an aluminum-containing paste may be applied to the back side and fired before the application of the back side metal coating. The residue from the fired aluminum-containing paste may optionally be removed prior to the application of the back side metal coating. In an alternate embodiment, a seed layer may be deposited on the back side of the wafer and a metal coating may be deposited on the seed layer by electroless or electrolytic plating.

The front side of the wafer may optionally be subjected to crystal-oriented texture etching in order to impart to the surface an improved light incidence geometry which reduces reflections, such as pyramid formation. To produce the semiconductor junction, phosphorus diffusion or ion implantation takes place on the front side of the wafer to produce an n-doped (n+ or n++) region and provides the wafer with a PN junction. The n-doped region may be referred to as the emitter layer.

An anti-reflective layer is added to the front side or emitter layer of the wafer. In addition the anti-reflective layer may serve as a passivation layer. Suitable anti-reflective layers include, without limitation, silicon oxide layers such as SiOₓ, silicon nitride layers such as Si₃N₄, a combination of silicon oxide and silicon nitride layers, and combinations of a silicon oxide layer, a silicon nitride layer with a titanium oxide layer such as TiOₓ. In the foregoing formulae, x is the number of oxygen atoms. Such anti-reflective layers may be deposited by a number of techniques, such as by various vapor deposition methods, for example, chemical vapor deposition and physical vapor deposition.

The front side of a wafer is metallized to form a metallized pattern of current tracks and busbars. The current tracks are typically transverse to the busbars and typically have a relatively fine-structure (i.e. dimensions) relative to the busbars.

Current tracks are formed with metal paste containing silver. The silver paste is selectively applied to the surface of the anti-reflective layer, such as silicon nitride, to a desired thickness depending on the thickness of the final desired current tracks. The amount may vary and such amounts are well known to those of skill in the art. In addition to silver, the paste may include an organic binder and a glass matrix in which electrically conductive particles are embedded. Such pastes are well known in the art and are commercially available. The specific formulations differ depending on the manufacturer, thus the paste formulations are in general proprietary. The paste may be applied by conventional methods used in the formation of current tracks on semiconductors. Such methods include, but are not limited to, screen printing, template printing, dabber printing, paste inscription and rolling on. The pastes possess viscosities suitable for such application methods.

The semiconductor with the paste is placed in a firing oven to burn through the anti-reflective layer to allow the paste to form a contact between the metal of the paste and the front side or emitter layer of the semiconductor. Conventional firing methods may be used. Typically paste firing is done at standard room atmosphere. Such methods are well known in the art.

Prior to metal plating the semiconductor may be edge masked to prevent any undesired edge plating. Edge masking reduces the probability of shunting the semiconductor wafer during metallization due to bridging of metal deposits from the n-type emitter layer to the p-type layer of the semiconductor wafer. Conventional plating tape may be used. A commercially available example of such tape is 3M Circuit Plating Tape™ 1280 (available from 3M Company).

A barrier layer is then deposited onto the fired metal paste. Various metals may be used to form the barrier layer. Such barrier layers may range from 20nm to 3µm thick. Preferably the metals are nickel, titanium or tungsten. Most preferably the metal is nickel. Such barrier layers may be deposited by using conventional electroless, electrolytic, LIP, sputtering, chemical vapor deposition and physical vapor deposition methods well known in the art. Typically titanium and tungsten are deposited by sputtering, physical or chemical vapor deposition. Conventional sources of titanium and tungsten as well as deposition parameters may be used. In general, metal plating baths used to plate metal have a pH of 1.5 and greater, preferably 2 or greater, more preferably 2 to 10. Conventional plating parameters, such as temperature, voltage and current densities, may be used to plate the barrier layer. Preferably, the metal barrier layer is deposited by electrolytic plating or LIP. Most preferably, the metal is deposited by LIP. When plating is done by electroplating it is typically front contact plating and LIP is typically done by rear contact plating.

When electroplating, a rear side potential (rectifier) is applied to the semiconductor wafer substrate. In general, current densities for plating the barrier layer may range from 0.1 ASD to 10 ASD, typically from 0.1 ASD to 2 ASD, more typically from 0.5 ASD to 1.5 ASD. When the metal is plated using LIP, a light source is applied to the emitter layer of the semiconductor. The light may be continuous or pulsed. Light which may be used includes, but is not limited to, visible light, infrared, UV and X-rays. Light sources include, but are not limited to, 75 watt and 250 watt incandescent lamps, LEDs, infrared lamps, fluorescent lamps, halogen lamps, 150 watt IR lamps and lasers. In general, light intensities applied to the emitter layer may range from 400 lx to 20,000 lx, or such as from 500 lx to 7500 lx.

Nickel ions may be provided by using one or more bath-soluble nickel compounds, typically one or more water soluble nickel salts are used. Such nickel compounds include, but are not limited to, nickel sulfate, nickel chloride, nickel sulfamate, and nickel phosphate. In general, the nickel compounds are added to the plating bath in amounts of 0.1 g/L to 150 g/L. Such nickel compounds are generally commercially available from a variety of sources, such as Aldrich Chemical Company, Milwaukee, Wisconsin.

In addition to the nickel salts, the plating baths may typically include, without limitation, one or more of electrolytes, surfactants, reducing agents and buffering agents. In general, such bath additives are well known in the literature or commercially available, such as from Aldrich Chemical Company.

Exemplary electrolytes include, without limitation, alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; sulfamic acid; mineral acids, such as hydrochloric acid and nitric acid; carboxylic acids such as formic acid; and pyrophosphate. Salts of acids and bases also may be used as the electrolyte. Further, the electrolyte may contain a mixture of acids, a mixture of bases or a mixture of one or more acids with one or more bases. Such electrolytes are included in conventional amounts.

A wide variety of conventional surfactants may be used in the metal plating baths. Any of anionic, cationic, amphoteric and nonionic surfactants may be used as long as it does not interfere with the performance of the metal plating. Surfactants may be included in conventional amounts. Such amounts are well known in the art.

The nickel plating baths may optionally contain a buffering agent. Exemplary buffering agents include, but are not limited to, borate buffer (such as borax), phosphate buffer, citrate buffer, carbonate buffer, such as sodium carbonate and sodium bicarbonate, and hydroxide buffer, such as sodium and potassium hydroxide and ammonium hydroxide. The amount of the buffer used is that amount sufficient to maintain the pH of the nickel plating bath at 2 or greater, preferably from 3-10.

Optionally, the nickel plating compositions may further contain one or more brighteners, grain refiners, complexing agents, chelating agents and ductility enhancers. Such additional components are well known in the art and are used in conventional amounts.

After the barrier layer is deposited on the fired metal paste a copper layer is deposited adjacent the barrier layer. The copper baths have a pH range of 1.5-4, preferably from 2.5-3.5. Operation within the specified pH range reduces attack of the fired paste at the fired paste and silicon interface, thus reducing risk of adhesion loss.

Preferably, the copper layer is deposited adjacent the barrier layer by electrolytic plating or LIP. Prior to copper plating the semiconductor may be edge masked to prevent any undesired edge plating as described above. When plating is done by electroplating, it is typically front contact plating and LIP is typically done by rear contact plating. Current density during copper plating may range from 0.01 ASD to 10 ASD, preferably from 4 ASD to 6 ASD. When LIP is used to plate the copper, light is applied to the front side of the semiconductor wafer substrate and a rear side potential (rectifier) is applied to the wafer substrate. By illuminating the front of the semiconductor wafer with light energy, plating occurs on the front. The impinging light energy generates a current in the semiconductor. The light may be continuous or pulsed. Pulsed illumination can be achieved, for example, by interrupting the light with a mechanical chopper or an electronic device may be used to cycle power to the lights intermittently based on a desired cycle. Light which may be used to plate is described above. In general the amount of light applied to the semiconductor wafer during plating may be from 10,000 lx to 70,000 lx, or such as from 30,000 lx to 50,000 lx.

One or more sources of copper ions may be provided in the form of bath-soluble salts. Typically one or more water soluble copper salts are added to the bath. Copper compounds include, but are not limited to, cupric oxalate, cuprous chloride, cupric chloride, copper sulfate, copper oxide and copper methane sulfonate. Preferably the copper compounds are copper sulfate and copper methane sulfonate. One or more copper compounds may be included in the copper baths in conventional amounts. Typically the copper compounds are included in amounts of 1 g/L to 150 g/L or such as from 5 g/L to 100 g/L.

Nitrate ions, sulfate, bisulfate or mixtures thereof are provided as an electrolyte to compensate for the low acid concentrations in the copper bath. Sources of nitrate ions include, but are not limited to, alkali nitrates, such as potassium nitrate and sodium nitrate. Preferably, the source of nitrate ions is potassium nitrate and sodium nitrate. More preferably, the source of nitrate ions is potassium nitrate. Sources of sulfate and bisulfate include, but are not limited to, alkali metal sulfates and bisulfates, preferably sodium sulfate and potassium bisulfate are used. Most preferably nitrate ions are included in the bath. Sources of nitrate, sulfate and bisulfate ions are included in the copper plating baths in amounts of 5 g/L to 100 g/L.

In addition to nitrate, sulfate and bisulfate ions, the copper baths may also include one or more electrolytes, such as alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; sulfamic acid; carboxylic acids such as formic acid; and pyrophosphate. Salts of such compounds also may be used. Such electrolytes are included in amounts to maintain the electrical conductivity of the copper bath without altering the pH of the bath to undesired levels.

Chloride and bromide ions are also included in the copper baths. Chloride is preferably provided by hydrochloric acid, sodium chloride or mixtures thereof. Bromide is preferably provided by sodium bromide, potassium bromide or mixtures thereof. These halogen ions are preferably included in the copper baths in amounts of 1ppm to 100ppm, more preferably from 60ppm to 80ppm. Other halogens, such as fluoride and iodide are preferably excluded from the bath. In general all halogens corrode the backside aluminum and silver fired paste electrodes and fluoride is corrosive to both the backside aluminum and silver fired paste as well as the front side fired silver past.

Complexing agents may also be included in the copper plating baths. Such complexing agents include, but are not limited to, citrate, gluconate and thiosulfate. Amounts of complexing agents are included in the plating copper bath depend on the amount of copper in the bath. Typically the molar ratio of copper to complexing agent is from 1:1 to 1:5. A typical range of complexing agent concentration is from 4 g/L to 300 g/L.

The pH may be adjusted with any base or alkali salt that is compatible with the plating composition. Such bases include, but are not limited to, sodium hydroxide, potassium hydroxide, ammonium hydroxide and sodium carbonate.

Additives to improve the brightness and uniformity of the plated copper may be added in the copper plating baths. Such additives include, but are not limited to, organic amine compounds, such as triethylene tetramine and tetraethylene pentamine, and oxyalkyl polyamines, such as polyoxypropyl-triamine. The amount of amine used depends on its activity in the bath, i.e., its ability to brighten the deposit. Conventional amounts well known in the art may be included.

The copper plating bath may be prepared over a wide temperature range. Typically it is prepared at room temperature. During copper plating the temperature of the copper plating bath may range from 20° C to 40° C or such as from 20° C to 28° C.

The copper layer deposited adjacent the barrier layer may range from 1µm to 50µm thick, preferably from 5µm to 25µm thick. Typically a tin, tin/lead or silver flash layer is then deposited onto the copper to prevent oxidation of the copper layer. The tin or silver flash layer may range from 0.25µm to 2µm. Also an organic solderability preservative may be applied to the copper, silver or tin layer. Such organic solubility preservative layers are well known in the art. They are applied form solution having pH ranges of 2 or greater.

When silver is used to deposit the flash layer, current densities may range from 0.1 ASD to 10 ASD. The pH of silver baths ranges from 2 or greater, preferably 3-10. Sources of silver ions may include, without limitation: silver nitrate, silver sodium thiosulfate, silver gluconate, silver-amino acid complexes such as silver-cysteine complexes, silver alkyl sulfonates, such as silver methane sulfonate. Mixtures of silver compounds may be used. The concentration of silver compounds in the baths may range from 2 g/L to 40 g/L. Such silver compounds are generally commercially available from a variety of sources, such as Aldrich Chemical Company, Milwaukee, Wisconsin. While the silver baths may include conventional additives and electrolytes in conventional amounts, it is preferred that the silver baths exclude halogen compounds and sulfuric acid. Examples of commercially available silver plating baths are ENLIGHT™ Silver Plate 600 and 620 from Rohm and Haas Electronic Materials, LLC Marlborough, Massachusetts.

Tin plating may be done by conventional electroless and electrolytic methods including LIP. The pH of such tin baths is from 2 or greater, preferably from 2-7. When electroplating or LIP, current densities may range from 0.1 ASD to 3 ASD.

Bath soluble tin compounds include, but are not limited to salts, such as tin sulfates, tin alkane sulfonate and tin alkanol sulfonates. The tin compound is typically tin sulfate or tin alkane sulfonate. The tin compounds are generally commercially available or may be prepared by methods known in the literature. Mixtures of solution soluble tin compounds may also be used. Typically, tin compounds are used in amounts of 5 to 100 g/L.

Electrolytes which may be added in the tin baths include, but are not limited to arylsulfonic acids, alkanesulfonic acids, such as methanesulfonic acid, ethanesulfonic acid and propanesulfonic acid, aryl sulfonic acids such as phenylsulfonic acid and tolylsulfonic acid, sulfamic acid and hydrochloric acid. Preferred acids are alkane sulfonic acids and aryl sulfonic acids. The amount of electrolyte added to the bath is typically in the range of 0.01 to 500 g/L.

One or more of thiourea and thiourea derivatives may be included in the tin baths. Thiourea derivatives include, for example, 1-allyl-2-thiourea, 1,1,3,3-tetramethyl-2-thiourea, thiourea 1,3-diethyl, thiourea 1,3-dimethyl, thiourea 1-methyl, thiourea 1-(3-tolyl), thiourea 1,1,3-trimethyl, thiourea 1-(2-tolyl), thiourea 1,3 -di(2-tolyl), and combinations thereof. Typically, the thiourea derivative is present in amounts of 0.01 to 50 g/L.

A reducing agent may be added to tin bath to assist in keeping the tin in a soluble, divalent state. Suitable reducing agents include, but are not limited to, hydroquinone and hydroxylated aromatic compounds, such as resorcinol and catechol. Typically, such reducing agents when used in the electrolyte composition are present in an amount of from 0.01 to 10 g/L.

The tin plating baths may further contain one or more brighteners, grain refiners, complexing agents, chelating agents, surfactants and ductility enhancers. Such additional components are well known in the art and are used in conventional amounts.

The methods enable the plating of metals on fired metal paste with minimal or no corrosion of the paste. In general, the metal plating baths used to deposit metals on the fired metal paste have pH ranges of 1.5 or greater, preferably 2 or greater, more preferably 2-10. Accordingly, the aesthetics of the semiconductor as well as the adhesion of the metals to the semiconductor are not compromised. Typically the metal adhesion has a value of 2N and greater as measured using a conventional solder flux adhesion test.

Adhesion may be lost on the front and backside fired paste during plating or soldering operations due to low pH values below 1.5. All halogen sources promote corrosion on the backside electrodes, particularly aluminum and silver fired paste electrodes. Although there are applications and plating equipment sets that do not allow metal plating baths to contact the backside of the substrate during plating, therefore no corrosion occurs on the backside, however, the front side paste is always exposed to the metal plating baths and is at risk for corrosion. In addition to free acid, fluoride is particularly corrosive to the front side fired paste and negatively impacts adhesion of metal to the metal frit. Accordingly, fluoride compounds are preferably excluded from the metal baths. Therefore, control of free acid and pH as well as halogen content of the metal plating bath is highly desired.

The following examples are included to illustrate the invention but are not intended to limit the scope of the invention.

### Examples 1 (Comparative)

A front contact monocrystalline silicon solar cell with a fired silver paste front electrode and a fired aluminum paste rear electrode was provided. The front (light collecting) surface had been previously textured, phosphorus doped to create an emitter layer and coated with a silicon nitride antireflective layer, prior to application and firing of the silver and aluminum paste. The solar cell was immersed into an electrolytic nickel plating bath as shown in Table 1 below.

**Table 1**

| **COMPONENT** | **AMOUNT** |
|---|---|
| Nickel as nickel sulfamate | 30 g/L |
| Nickel as nickel chloride | 8 g/L |
| Boric acid | 40 g/L |
| ENLIGHT™ 1405 wetting agent | 1% v/v |

The pH of the nickel bath was maintained at 4 and the temperature of the bath was 40° C. The perimeter of the solar cell was taped to a metal plating rack with 3M Circuit Plating Tape™ 1280 such that the backside aluminum electrode contacted the metal plating rack and the tape prevented the nickel bath from penetrating between the solar cell and the rack. The backside of the metal rack was also masked with the plating tape to prevent plating on the rear side of the rack and simplify calculation of plating current density. A rectifier was connected between the plating rack which contacted the rear side aluminum of the solar cell and a soluble nickel electrode, which served as the anode. The current density during electroplating was 2 ASD. Light from a 250 Watt halogen lamp was applied to the front side of the solar cell. Nickel LIP was done for 2.5 minutes to deposit 1 µm thick nickel layer on the fired silver paste.

After nickel LIP the solar cell was removed from the nickel bath, rinsed with water and tehn immersed into a copper electroplating bath as shown in Table 2 below.

**Table 2**

| **COMPONENT** | **AMOUNT** |
|---|---|
| Copper from copper sulfate pentahydrate | 75 g/L |
| Sulfuric acid | 200 g/L |
| Hydrochloric acid | 90 ppm |
| Polyethylene glycol | 0.7 g/L |
| Reaction product of thiodicarbonic tetramethyl and 1,2-oxathiolane-2,2-dioxide | 0.03 g/L |

The pH of the copper bath was measured at 0 and the temperature of the bath was 20° C. The plating rack in contact with the rear aluminum electrode of the solar cell was connected to a rectifier and a soluble copper electrode functioned as the anode. The current density during electroplating was 4 ASD with a plating voltage of 1.1 V. Light from a 250 Watt halogen lamp was applied to the front of the solar cell. Copper LIP was done for 8 minutes to deposit a layer of copper 8 µm thick on the nickel layer. The conductivity of the copper plating solution was determined to be 750 mS.

The copper plated solar cell was removed from the copper bath, rinsed with water and then plated into a bath of ENLIGHT™ 620 Silver Electroplating solution having a pH greater than 2. The silver ion concentration was 20 g/L and the temperature was 35°C. The plating rack in contact with the rear aluminum electrode of the solar cell was connected to a rectifier and a soluble silver electrode functioned as the anode. The current density during electroplating was 1.5 ASD. Light from a 250 Watt halogen lamp was applied to the front side of the solar cell. Silver LIP was done for 1 minute to deposit a layer of silver 1 µm thick on the copper layer.

The adhesion of the metal layers was then tested in several areas using Scotch transparent tape CAT.# 600. The tape was applied to the metal layers and hand pulled from the solar cell. The solar cell failed the tape test. All of the metal layers along with the fired silver paste were pulled from the cell. Next the adhesion of the front side metallization was measured along the bus area using a solder pull strength test. Solder was fluxed to a 1.5mm wide ribbon containing 62%Sn, 36%Pb and 2%Ag (available from Indium Corporation of America). The solar cell was heated to 70° C on an isotemp baic ceramic hotplate and the ribbon was soldered onto the metal layers of the solar cell using a Weller WDI soldering iron applied at 360° C. A pull test was performed using GP STAB-TEST (available from GP Solar). The force determined to pull the metal layers from each wafer was less than 1N indicating that the metal layers were not acceptable for many commercial applications.

### Example 2 (Comparative)

The metallization method described in Example 1 was repeated using the same type of solar cell, metal plating baths and LIP parameters except that the copper bath had 20 g/L of sulfuric acid instead of 200 g/L with a measured pH of 0.7. The conductivity of the copper plating bath was measured to be 73 mS. The current density during electroplating was 4 ASD with a plating voltage of 5.5V. After metallization was completed the adhesion of the metal layers were tested using Scotch transparent tape Cat.# 600. The tape was applied to the metal layers and hand pulled from the solar cell. The solar cell failed the tape test. All of the metal layers along with the fired silver paste were pulled from the cell.

Next the adhesion of the front side metallization was measured along the bus area using a solder pull strength test. Solder flux was applied to a 1.5mm wide ribbon containing 62%Sn, 36%Pb and 2%Ag. The solar cell was heated to 70° C on an isotemp basic ceramic hotplate and the ribbon was soldered onto the metal layers of the solar cell using a Weller WDI soldering iron applied at 360° C. A pull test was performed using GP STAB-TEST (available from GP Solar). The force determined to pull the metal layers from each wafer was less than 1N indicating that the metal layers were not acceptable for many commercial applications.

### Example 3

The metallization method described in Example 1 was repeated using the same type of solar cell, metal plating baths and LIP parameters except that the copper bath had less than 10 g/L of sulfuric acid instead of 200 g/L. The pH of the copper bath was 2. The conductivity of the copper plating bath was measured to be 48 mS. After metallization was completed the adhesion of the metal layers was tested using Scotch transparent tape Cat.# 600. The tape was applied to the metal layers and hand pulled from the solar cell. The metal layers remained intact on the solar cell. There was no indication of any adhesion failure.

Next the adhesion of the front side metallization was measured along the bus area using a solder pull strength test. Solder flux was applied to a 1.5mm wide ribbon containing 62%Sn, 36%Pb and 2%Ag. The solar cell was heated to 70° C on an isotemp basic ceramic hotplate and the ribbon was soldered onto the metal layers of the solar cell using a Weller WDI soldering iron applied at 360° C. A pull test was performed using GP STAB-TEST (available from GP Solar). The force determined to pull the metal layers from each wafer was 4-6N indicating that the metal layers were acceptable for commercial applications.

### Example 4

The method described in Example 1 was repeated with the same type of solar cell and metal plating baths except that the sulfuric acid concentration in the copper bath was less than 10 g/L and 50 g/L of potassium nitrate was added to the copper bath to compensate for the drop in bath conductivity due to the reduction in the amount of sulfuric acid. The pH of the copper plating bath was 3 and the bath conductivity was measured to be 86 mS. After metallization was completed the adhesion of the metal layers was tested using Scotch transparent tape Cat.# 600. The tape was applied to the metal layers and hand pulled from the solar cell. The metal layers remained intact on the solar cell. There was no indication of any adhesion failure.

The adhesion of the metal layers was then tested by soldering a ribbon to the bus as described in the above examples. The solder pull value was determined to be 4-6N. Accordingly, the metal layers were acceptable for commercial applications.

### Example 5 (Comparative)

The method described in Example 4 was repeated with the same type of solar cell and metal plating baths except that the silver layer was substituted with a tin layer. Cell racking, lighting and rectifier connections were the same as described in Example 1. The tin was deposited from RONASTAN™ EC-1 Tin Electroplating solution. The concentration of sulfuric acid in the tin electroplating solution was 180 g/L. The pH of the tin bath was ≤ 1. The current density during electroplating was 1.5 ASD. Light from a 250 Watt halogen lamp was applied to the front side of the solar cell. Tin LIP was done for 1.5 minutes to deposit a layer of tin 1 to 1.5 µm thick on the copper layer.

After metallization was completed the adhesion of the metal layers was tested using Scotch transparent tape Cat.# 600. The tape was applied to the metal layers and hand pulled from the solar cell. All of the metal layers along with the fired silver paste were pulled from the cell. The solar cell failed the tape test.

Another solar cell of the same type was metalized using the same plating baths and plating parameters. After the LIP was complete, adhesion of the metal layers was tested. Solder flux was applied to a 1.5mm wide ribbon containing 62%Sn, 36%Pb and 2%Ag. The solar cell was heated to 70° C on an isotemp basic ceramic hotplate and the ribbon was soldered onto the metal layers of the solar cell using a Weller WDI soldering iron applied at 360° C. A pull test was performed using GP STAB-TEST (available from GP Solar). The force determined to pull the metal layers from each wafer was less than 1N indicating that the metal layers were not acceptable for many commercial applications.

### Example 6

The method described in Example 5 was repeated with the same type of solar cell and metal plating baths except that the tin bath used was SOLDERON™ LG-M1 Tin Electroplating solution which had a pH of 3. The current density during electroplating was 1.5 ASD. Light from a 250 Watt halogen lamp was applied to the front side of the solar cell. Tin LIP was done for 1.5 minutes to deposit a layer of tin 1.5 µm thick on the copper layer.

After metallization was completed the adhesion of the metal layers was tested using Scotch transparent tape Cat.# 600. The tape was applied to the metal layers and hand pulled from the solar cell. The metal layers remained intact on the solar cell. There was no indication of any adhesion failure.

The adhesion of the metal layers was then tested using solder flux as described in the above examples. The solder pull value was determined to be 4-6N. Accordingly, the metal layers were acceptable for commercial applications.

## Claims

1. A method comprising:
a) providing a semiconductor comprising a front side, a metalized back side, and a PN junction, the front side comprises a pattern of conductive tracks comprising fired metal paste;
b) depositing a barrier layer on the conductive tracks;
c) contacting the semiconductor with a copper plating bath comprising one or more sources of copper ions, one or more sources of chloride and bromide ions, one or more sources of nitrate ions, sulfate ions and bisulfate ions, and a pH of 1.5-4; and
d) plating a copper layer adjacent the barrier layer of the fired metal paste of the conductive tracks.

2. The method of claim 1, further comprising depositing a metal layer adjacent the copper layer from a source comprising a pH of 2 or greater.

3. The method of claim 2, wherein the metal layer is a metal chosen from silver and tin.

4. The method of claim 1, wherein the chloride, bromide or mixtures of chloride and bromide ions range from 1-100ppm.

5. The method of claim 1, wherein the barrier layer is a metal chosen from nickel, tungsten and titanium.

6. The method of claim 1, further comprising depositing an organic solderability preservative adjacent the copper layer from a solution comprising a pH of 2 or greater.

7. A composition comprising one or more sources of copper ions, one or more sources of chloride and bromide ions, one or more sources of nitrate ions, sulfate ions and bisulfate ions, and a pH of 1.5-4.

8. The composition of claim 7, wherein the one or more sources of nitrate ions are chosen from alkali metal nitrates.

9. The composition of claim 8, wherein the one or more sources of nitrate ions range from 5-100 g/L.

10. The composition of claim 7, wherein the chloride, bromide, or mixtures of chloride and bromide ions range from 1-100ppm.
